# EUROPEAN PATENT APPLICATION

(11) **EP 2 402 485 A1**
(43) Date of publication of application: **04.01.2012**
(21) Application number: 10746116.2
(22) Date of filing: 17.02.2010
(51) Int. Cl.: C23C 28/02, B32B 15/088, C23C 18/20, C25D 5/56, H05K 3/24, H05K 3/38

(54) **METAL-COATED POLYIMIDE RESIN SUBSTRATE WITH EXCELLENT THERMAL AGING RESISTANCE PROPERTIES**

(30) Priority: 25.02.2009 JP 2009041814
(71) Applicant: JX Nippon Mining & Metals Corporation, Tokyo 100-8164 (JP)
(72) Inventor: YOSHIDA Taku, Hitachi-city Ibaraki 317-0056 (JP)
(74) Representative: Hoarton, Lloyd Douglas Charles
(86) International application number: PCT/JP2010/052298
(87) International publication number: WO 2010/098235

(57) **Abstract**

[Object] To provide a metal-coated polyimide resin substrate that does not deteriorate the initial adhesion between the metal-coated polyimide resin film and the metal layer and has high adhesion after aging at 150°C for 168 hours.

[solution] A metal-coated polyimide resin substrate in which a barrier layer is formed by a wet process after performing surface modification to one surface or both surfaces of a polyimide resin film by a wet process or a dry process or a combination thereof, a seed layer is thereafter formed by a wet process or a dry process, and a conductive film is formed on a surface layer thereof by a wet process; wherein, at the peeling surface on the conductive film layer side after the metal-coated polyimide resin substrate is subject to a 90-degree peel test, the thickness of a mixed layer of polyimide; residue and barrier metal layer residue according to in-depth profiting with a time-of-flight secondary ion mass spectrometer (TOF-SIMS) is 2.60 nm or less based on Si sputter rate conversion, and peel strength retention after an aging test at 150°C for 168 hours (peel strength after aging at 150°C for 168 hours/initial peel strength) is 50% or higher.

## Description

### TECHNICAL FIELD

The present invention relates to an adhesive-free flexible laminate material for use as a mounting material of electronic components such as a flexible print substrate, TAB and COF, and in particular relates to a metal-coated polyimide resin substrate with excellent thermal aging resistance properties.

### BACKGROUND ART

An FCCL (Flexible Copper Clad Laminate), in which metal conductor layers primarily formed from copper are laminated on a polyimide film, is broadly used as a circuit board material in the electronics industry. Among the above, an adhesive-free flexible laminate (particularly a two-layer flexible laminate) that does not comprise an adhesive layer between a polyimide film and a metal layer is attracting attention pursuant to the demands of finer pitches of the circuit wiring width.

As a method of producing an adhesive-free flexible laminate, in particular an adhesive-free flexible laminate capable of accommodating fine pitches; there is a so-called metalizing method, in which a barrier layer and a seed layer are formed on a polyimide resin film in advance by a dry plating method such as sputtering, CVD or vapor deposition, and a metal layer as a conductor layer is subsequently deposited by electrolytic planting.
In this metalizing method, in order to increase the adhesion between the metal layer and the polyimide film, prior to forming the metal layer, surface modification is performed for the purpose of improving the adhesiveness with the barrier metal by subjecting the polyimide resin film surface to plasma treatment (refer to Patent Document 1 and Patent Document 2),

Moreover, also proposed is a method of forming a barrier layer and a seed layer on a polyimide resin film in advance by electroless plating, and subsequently depositing a metal layer as a conductor layer by electrolytic plating.
In this method, prior to forming the metal layer, surface modification is performed by immersing the polyimide resin film in a solution made of alkali metal hydroxide in order to improve the adsorption of the catalyst to serve as the drive force of the subsequent electroless plating, and to improve the adhesiveness with the barrier metal (refer to Patent Document 3).

The surface modification treatment of the polyimide resin film has a major impact on the adhesiveness between the polyimide resin film and the metal layer, and it is a particularly important treatment process in terms of production.

As the mechanical properties that are demanded in an adhesive-free flexible laminate, the initial peel strength and the peel strength after the lapse of a long period are important, and in recent years the long-term peel strength is becoming particularly important as a requirement for high reliability.
Moreover, as the evaluation method of the long-term peel strength, the long-term peel strength is generally evaluated based on peel measurement after thermal aging (at 150°C for 168 hours), which is an accelerated deterioration test.

In recent years, proposed is a method of staining the polyimide resin film that was subject to modification treatment with a silver nitrate solution, observing the cross section thereof under a transmission electron microscope (TEM), and deciding the initial peel strength and the peel strength after (thermal aging according to the thickness of the modification layer (refer to Patent Document 4).
Nevertheless, in the actual surface modification of the polyimide resin film, according to the treatment conditions, substances of various molecular structures including functional groups that contribute to the adhesiveness are created. Thus, with the foregoing method, the surface modification layer that is stained with silver nitrate is evaluated only with a specific substance. Even if the thickness of the modification layer is the same in the foregoing evaluation, there was a problem in that differences would arise with the actual results of peel strength test.

Patent Document 1: Japanese Patent No. 3173511
Patent Document 2: Published Japanese Translation No. 2003-519901 of PCT Application
Patent Document 3: Japanese Laid-Open Patent Publication No. 2005-154895
Patent Document 4: Japanese Laid-Open Patent Publication No. 2007-318177

### SUMMARY OF INVENTION

### [Problems to be Solved by the invention]

An object of this invention is to provide a metal-coated polyimide resin substrate that does not deteriorate the initial adhesion between the metal-coated polyimide resin film and the metal layer and has high adhesion after aging at 150°C for 168 hours.

### [Means for Solving the Problems]

In order to achieve the foregoing object, the present invention provides:
1) A metal-coated polyimide resin substrate in which a barrier layer is formed by a wet process after performing surface modification to one surface or both surfaces of a polyimide resin film by a wet process or a dry process or a combination thereof, a seed layer is thereafter formed by a wet process or a dry process, and a conductive film is formed on a surface layer thereof by a wet process; wherein, at the peeling surface on the conductive film layer side after the metal-coated polyimide resin substrate is subject to a 90-degree peel test, the thickness of a mixed layer of polyimide residue and barrier metal layer residue according to in-depth profiling with a time-of-flight secondary ion mass spectrometer (TOF-SIMS) is 2.60 nm or less based on Si sputter rate conversion, and peel strength retention after an aging test at 150°C for 168 hours (peel strength after aging at 150°C for 168 hours/initial peel strength) is 50% or higher.

The present invention additionally provides:
2) The metal-coated polyimide resin substrate according to 1) above, wherein the seed layer and the conductive film are copper and the barrier layer is nickel or an alloy thereof; and
3) The metal-coated polyimide resin substrate according to 1) or 2) above, wherein the surface modification of the polyimide resin film is performed based on plasma, UV, immersion treatment using an alkali metal hydroxide solution, or a combination of these and immersion treatment using a strong acid solution,

### EFFECTS OF INVENTION

The metal-coated polyimide resin substrate of the present invention yields superior effects in the formation of fine patterns as a result of being able to increase the adhesion after aging without deteriorating the initial adhesion between the polyimide film and the metal layer after lamination.

### BRIEF DESCRIPTION OF DRAWINGS

[Fig. 1] This is a diagram schematically showing the examination results on the thickness of a mixed layer of the polyimide residue and the barrier metal (Ni) layer residue at the peeling surface on the metal layer side according to in-depth profiling with a time-of-flight secondary ion mass spectrometer (TOF-SIMS).
[Fig. 2] This is a diagram showing the relationship between the thickness of polyimide mixed layer and the peel strength retention.

### DESCRIPTION OF EMBODIMENTS

Generally speaking, a metal-coated polyimide resin substrate is produced by forming a barrier layer after performing surface modification to one surface or both surfaces of a polyimide resin film by a wet process or a dry process, forming a seed layer on the foregoing barrier layer, and additionally forming a conductive film with a given thickness on the foregoing seed layer.
An adhesive-free flexible laminate (particularly a two-layer flexible laminate), which does not comprise an adhesive layer between the polyimide film produced as described above and a metal layer, is known as an FCCL (Flexible Copper Clad Laminate) which is broadly used as a circuit board material in the electronics industry; but greater adhesion between the metal layer and the polyimide film is being demanded pursuant to the demands of finer pitches of the circuit wiring width in recent years.

As the evaluation method thereof, the normal peel strength (initial peel strength) and the peel strength after thermal aging (aging at 150°C for 168 hours) as the accelerated deterioration test are generally measured.
As described above, in recent years the long-term peel strength is becoming particularly important as a requirement for high reliability, and there are demands for increasing the peel strength retention after an aging test at 150°C for 168 hours (thermal peel strength/normal peel strength) as much as possible.

In order to increase the peel strength retention, it is known that surface modification treatment based on a wet process or a dry process is preferably performed on the surface of the polyimide resin film, but it is not sufficiently understood by what sort of mechanism or phenomenon the peel strength increases, and there is a problem in that the modification treatment is being implemented through trial and error and it is difficult to maintain a given modification level.

In light of the above, the present inventors conduced intense study regarding the structure of the peeling surface on the metal layer side in the depth direction when the metal-coated polyimide resin substrate was subject to 90-degree peeling. It was discovered thereby there is a mixed layer of the barrier layer (nickel or its alloy layer) formed after the surface modification treatment and the polyimide.
Although this will depend on the modification treatment of the polyimide resin, generally speaking, if the modification treatment is excessive, the incorporation of the barrier layer metal into the polyimide modification layer will increase, and the mixed layer of the barrier layer metal and polyimide gets thicker.

It was additionally discovered that the deterioration in the peel strength after thermal aging was caused by the thickness of the mixed layer of polyimide and barrier layer metal at the initial peeling surface on the metal layer side.
In other words, it was discovered that, as the mixed layer of polyimide and barrier layer metal becomes thicker, the copper with a catalytic oxidation effect is more easily dispersed in the polyimide layer through the mixed layer, and the peel strength deteriorates in the thermal aging.
Accordingly, by adjusting the thickness of the mixed layer of polyimide and metal at the peeling surface on the metal layer side in the initial peel, it is possible to maintain the peel strength after thermal aging at a high level, and additionally possible to estimate the peel strength after the thermal aging from the thickness of the mixed layer of polyimide and metal at the initial peeling surface on the metal layer side.

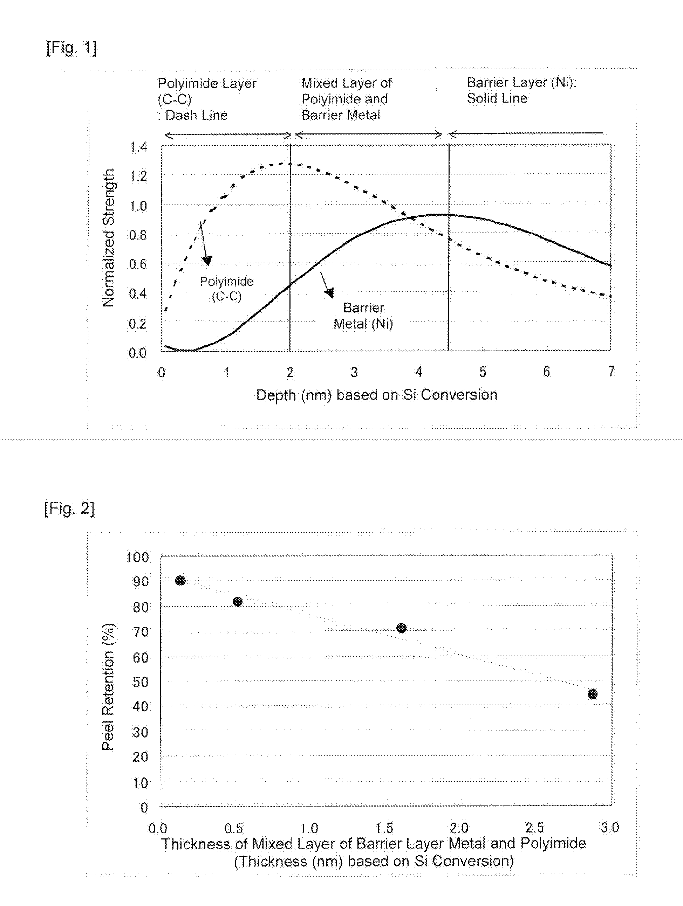

Fig. 1 is a diagram schematically showing the examination results on the thickness of a mixed layer of the polyimide residue and the barrier metal (Ni) layer residue at the peeling surface on the metal layer side according to in-depth profiling with a time-of-flight secondary ion mass spectrometer (TOF-SIMS).
As shown in Fig. 1, the polyimide residue (C-C) reaches its peak in the vicinity of 2 nm as the sputter depth based on Si conversion, and the barrier metal (Ni) reaches its peak in the vicinity of 4.5 nm as the sputter depth based on Si conversion. The intermediate thereof is the mixed layer of polyimide and metal.
As evident from the Examples and Comparative Examples described later, it was found that this mixed layer causes the peel strength retention to deteriorate.

Accordingly, based on a great deal of research, the present inventors discovered that the peel strength retention after an aging test at 150°C for 168 hours (thermal peel strength/normal peel strength) will increase when the thickness of a mixed layer of polyimide and barrier metal layer at the peeling surface on the metal layer side according to in-depth profiling with TOF-SIMS is 2.60 nm or less based on Si sputter rate conversion. In the foregoing case, it was possible to achieve peel strength retention of 50% or higher.

### [Examples]

The Examples and Comparative Examples of the present invention are now explained. These Examples are merely illustrative, and the present invention shall in no way be limited thereby. In other words, various modifications and other embodiments based on the technical spirit claimed in the claims shall be included in the present invention as a matter of course.

### (Example 1)

As the polyimide resin film, Kapton 150EN manufactured by Du Pont was used. The polyimide resin film was immersed in a potassium hydroxide solution as the surface modification process, and washed with deionized water. Subsequently, as the catalyst-adding step, the foregoing polyimide resin film was immersed in a solution in which a silane coupling agent containing a functional group with metal binding capability was mixed or reacted with a noble metal compound, and washed with deionized water.

After the foregoing treatment, as the electroless plating step, an electroless nickel-boron-based plating solution was used to form a nickel layer of 0.15 µm, this was washed with deionized water, heat treatment was thereafter performed at 150°C to form a nickel layer of 0.05 µm, this was washed with deionized water, and a nickel layer in a total amount of 0.20 µm was formed. Subsequently, an electroless copper seed layer was formed on the nickel layer with an electroless copper plating solution, and a copper conductor layer of 8 µm was thereafter formed by electroplating.

The strength on 90-degree peeling was measured regarding the metal-coated polyimide resin substrate formed as described above, and the thickness of the mixed layer of polyimide and barrier layer metal at the peeling surface on the metal layer side was measured according to in-depth profiling with the time-of-flight secondary ion mass spectrometer (TOF-SIMS).
The foregoing measurement results are shown in Table 1.

**[Table 1]**

| | Normal Peel Strength (kN/m) | Thermal Peel Strength (kN/m) | Peel Strength Retention (%) | Mixed Layer of Polyimide and Barrier Metal (Si Equivalent nm) |
|---|---|---|---|---|
| Example 1 | 0.55 | 0.45 | 82 | 0.51 |
| Example 2 | 0.61 | 0.55 | 90 | 0.13 |
| Example 3 | 0.56 | 0.39 | 70 | 1.60 |
| Comparative Example 1 | 0.63 | 0.28 | 44 | 2.87 |

As shown in Table 1, the normal peel strength was 0.55 kN/m, the thermal peel strength was 0.45 kN/m, and the peel strength retention (thermal peel strength/normal peel strength) was 82%. The mixed layer of Ni and polyimide measured by TOF-SIMS was 0.51 nm.
The thickness of this mixed layer of Ni and polyimide was small and satisfied the conditions of the present invention, and the peel strength retention consequently showed favorable properties at 82%.

### (Example 2)

As the polyimide resin film, Kapton 150EN manufactured by Du Pont was used. The polyimide resin film was subject to UV irradiation and thereafter immersed in sulfuric acid as the surface modification process, and this was subsequently washed with deionized water. Subsequently, as the catalyst-adding step, the foregoing polyimide resin film was immersed in a solution in which a silane coupling agent containing a functional group with metal binding capability was mixed or reacted with a noble metal compound, and washed with deionized water.
After the foregoing treatment, as the electroless plating step, an electroless nickel-boron-based plating solution was used to form a nickel layer of 0.2 µm, this was washed with deionized water. Subsequently, an electroless copper seed layer was formed on the nickel layer with an electroless copper plating solution, and a copper conductor layer of 8 µm was thereafter formed by electroplating.

The strength on 90-degree peeling was measured regarding the metal-coated polyimide resin substrate formed as described above, and the thickness of the mixed layer of polyimide and barrier layer metal at the peeling surface on the metal layer side was measured according to in-depth profiling with the time-of-flight secondary ion mass spectrometer (TOF-SIMS).
The foregoing measurement results are shown in Table 1.

As shown in Table 1, the normal peel strength was 0.61 kN/m, the thermal peel strength was 0.55 kN/m, and the peel strength retention (thermal peel strength/normal peel strength) was 90%. The mixed layer of Ni and polyimide measured by TOF-SIMS was 0.13 nm.
The thickness of this mixed layer of Ni and polyimide was satisfied the conditions of the present invention, and the peel strength retention consequently showed extremely favorable properties at 90%.

### (Example 3)

As the polyimide resin film, Kapton 150EN manufactured by Du Pont was used. The polyimide resin film was subject to UV irradiation and thereafter immersed in nitric acid as the surface modification process, and this was subsequently washed with deionized water. Subsequently, as the catalyst-adding step, the foregoing polyimide resin film was immersed in a solution in which a silane coupling agent containing a functional group with metal binding capability was mixed or reacted with a noble mental compound, and washed with deionized water.
After the foregoing treatment, as the electroless plating step, an electroless nickel-boron-based plating solution was used to form a nickel layer of 0.15 µm, this was washed with deionized water, heat treatment was thereafter performed at 150°C to form a nickel layer of 0.05 µm, this was washed with deionized water, and a nickel layer in a total amount of 0.20 turn was formed. Subsequently, an electroless copper seed layer was formed on the nickel layer with an electroless copper plating solution, and a copper conductor layer of 8 µm was thereafter formed by electroplating.

The strength on 90-degree peeling was measured regarding the metal-coated polyimide resin substrate formed as described above, and the thickness of the mixed layer of polyimide and barrier layer metal at the peeling surface on the metal layer side was measured according to in-depth profiling with the time-of-flight secondary ion mass spectrometer (TOF-SIMS).
The foregoing measurement results are shown in Table 1.

As shown in Table 1, the normal peel strength was 0.56 kN/m, the thermal peel strength at 150°C for 168 hours was 0.39 kN/m, and the peel strength retention (thermal peel strength/normal peel strength) was 70%. The mixed layer of Ni and polyimide measured by TOF-SIMS was 1.60 nm.
The thickness of this mixed layer of Ni and polyimide was extremely small and satisfied the conditions of the present invention, and the peel strength retention consequently showed favorable properties at 70%.

### (Comparative Example 1)

As the polyimide resin film, Kapton 150EN manufactured by Du Pont was used. The polyimide resin film was immersed in a potassium hydroxide solution as the surface modification process, and subsequently washed with deionized water. Subsequently, as the catalyst-adding step, the foregoing polyimide resin film was immersed in a solution in which a silage coupling agent containing a functional group with metal binding capability was mixed or reacted with a noble metal compound, and washed with deionized water.
After the foregoing treatment, as the electroless plating step, an electroless nickel-boron-based plating solution was used to form a nickel stayer of 0.2 µm, and this was washed with deionized water. Subsequently, an electroless copper seed layer was formed on the nickel layer with an electroless copper plating solution, and a copper conductor layer of 8 µm was thereafter formed by electroplating,

The strength on 90-degree peeling was measured regarding the metal-coated polyimide resin substrate formed as described above, and the thickness of the mixed layer of polyimide and barrier layer metal at the peeling surface on the metal layer side was measured according to in-depth profiling with the time-of-flight secondary ion mass spectrometer (TOF-SIMS),
The foregoing measurement results are shown in Table 1,

As shown in Table 1, the normal peel strength was 0.63 kN/m, the thermal peel strength was 0.28 kN/m, and the peel strength retention (thermal peel strength/normal peel strength) was 44%. The mixed layer of Ni and polyimide measured by TOF-SIMS was 2.87 nm.
The thickness of this mixed layer of Ni and polyimide was large and did not satisfy the conditions of the present invention, and the peel strength retention was inferior at 44%.

The relationship between the thickness of polyimide mixed layer and the peel strength retention of the foregoing Examples and Comparative Example is shown in Fig. 2.
As evident from Fig. 2, as the thickness of the mixed layer of Ni and polyimide measured by TOF-SIMS becomes larger, the peel strength retention (thermal peel strength/normal peel strength) tends to deteriorate, and it was confirmed that the thickness of a mixed layer of polyimide residue and barrier metal layer residue needs to be 2.60 nm or less based on Si sputter rate conversion in order to achieve peel strength retention of 50% or higher.

### INDUSTRIAL APPLICABILITY

The present invention provides a metal-coated polyimide resin substrate in which a barrier layer is formed by a wet process after performing surface modification to one surface or both surfaces of a polyimide resin film by a wet process or a dry process or a combination thereof, a seed layer is thereafter formed by a wet process or a dry process, and a conductive film is formed on a surface layer thereof by a wet process; wherein, at the peeling surface on the conductive film layer side after the metal-coated polyimide resin substrate is subject to a 90-degree peel test, the thickness of a mixed layer of polyimide residue and barrier metal layer residue according to in-depth profiling with a time-of-flight secondary ion mass spectrometer (TOF-SIMS) is 2.60 nm or less based on Si sputter rate conversion, and peel strength retention after an aging test at 150°C for 168 hours (thermal peel strength/normal peel strength) is 50% or higher. In particular, the present invention yields superior effects in the formation of fine patterns as a result of increasing the adhesion after aging without deteriorating the initial adhesion between the polyimide film and the metal layer after lamination, and is therefore useful as an adhesive-free flexible laminate material for use as a mounting material of electronic components such as a flexible print substrate, TAB and COF, and in particular as a metal-coated polyimide resin substrate with excellent peel strength retention.

## Claims

1. A metal-coated polyimide resin substrate in which a barrier layer is formed by wet process after performing surface modification to one surface or both surfaces of a polyimide resin film by a wet process or a dry process or a combination thereof, a seed layer is thereafter formed by a wet process or a dry process, and a conductive film is formed on a surface layer thereof by a wet process; wherein, at the peeling surface on the conductive film layer side after the metal-coated polyimide resin substrate is subject to a 90-degree peel test, the thickness of a mixed layer of polyimide residue and barrier metal layer residue according to in-depth profiling with a time-of-flight secondary ion mass spectrometer (TOF-SIMS) is 2.60 nm or less based on Si sputter rate conversion, and peel strength retention after an aging test at 150°C for 168 hours (peel strength after aging at 150°C for 168 hours/initial peel strength) is 50% or higher.

2. The metal-coated polyimide resin substrate according to claim 1, wherein the seed layer and the conductive film are copper, the barrier layer is nickel or an alloy thereof, and these are formed by electroless plating.

3. The metal-coated polyimide resin substrate according to claim 1 or claim 2, wherein the surface modification of the polyimide resin film is performed based on plasma, UV, immersion treatment using an alkali metal hydroxide solution, or a combination of these and immersion treatment using a strong acid solution.
